# FASCICULE DE BREVET EUROPEEN

(11) **EP 3 191 550 B1**
(45) Date de publication et mention de la délivrance du brevet: **29.11.2023**
(21) Numéro de dépôt: 15771208.4
(22) Date de dépôt: 11.09.2015
(51) Int. Cl.: C09C 3/10, C09C 1/04, C09K 11/54, C09K 11/02

(54) **COMPOSITION AQUEUSE DE PARTICULES DE ZNO SUSPENDUES**
WÄSSRIGE ZUSAMMENSETZUNG MIT SUSPENDIERTEN ZNO-PARTIKELN
AQUEOUS COMPOSITION CONTAINING SUSPENDED ZNO PARTICLES

(30) Priorité: 12.09.2014 FR 1458575
(43) Date de publication de la demande: 19.07.2017
(73) Titulaire: Université Claude Bernard Lyon 1, 69622 Villeurbanne Cedex (FR); Centre National de la Recherche Scientifique, 75794 Paris Cedex 16 (FR)
(72) Inventeur: DANIELE, Stéphane, F-69330 Meyzieu (FR); VALETTE, Audrey, F-69330 Meyzieu (FR); CORNIER, Thibaut, F-69100 Villeurbanne (FR)
(74) Mandataire: Brevalex
(86) Numéro de dépôt international: PCT/FR2015/052434
(87) Numéro de publication internationale: WO 2016/038317

(56) Documents cités:
- EP-A1- 2 497 456
- WO-A1-2010/068687
- ANDREAS TAUBERT ET AL: "Kinetics and Particle Formation Mechanism of Zinc Oxide Particles in Polymer-Controlled Precipitation from Aqueous Solution", LANGMUIR, vol. 18, no. 11, 1 mai 2002 (2002-05-01), pages 4488-4494, XP055190799, ISSN: 0743-7463, DOI: 10.1021/la011799a

## Description

### DOMAINE DE L'INVENTION

La présente invention concerne une composition aqueuse contenant des particules de ZnO suspendues en présence d'un stabilisant ayant des fonctions acide carboxylique et sel d'acide carboxylique.

Le domaine d'utilisation de la présente invention concerne notamment les cellules photovoltaïques.

### ETAT ANTERIEUR DE LA TECHNIQUE

L'énergie solaire étant une source d'énergie renouvelable disponible gratuitement dans toutes les régions du monde, sa conversion en énergie électrique constitue un enjeu majeur pour les décennies à venir.

De manière générale, les dispositifs permettant ce type de conversion sont notamment des cellules photovoltaïques à base de silicium, des dispositifs à couches minces, des cellules à hétérojonction, ou des cellules à matériaux hybrides inorganique/organique.

Parmi ces différentes technologies, les dispositifs à base de silicium restent majoritaires. Ces derniers demandent néanmoins à être perfectionnés étant donné que leur rendement énergétique (conversion solaire/électrique) n'excède généralement pas 25% alors que la limite théorique est de l'ordre de 33,5%.

Cette perte de rendement (<25% vs 33,5%) est due à la capacité du silicium cristallin de n'absorber des photons que dans le domaine du visible et du proche infrarouge, généralement entre 300 et 1100 nm, avec un maximum à 600 nm. Le rayonnement électromagnétique provenant du soleil n'est donc que partiellement absorbé par le silicium.

Par conséquent, une des problématiques liées à l'amélioration du rendement des cellules à base de silicium consiste à absorber au moins une partie du rayonnement ultra-violet ou infrarouge. En fait, il s'agit d'absorber les photons du domaine ultraviolet ou infrarouge, et d'ensuite émettre des photons dans le domaine du visible dans lequel le silicium absorbe. Cette technologie consiste donc à modifier l'énergie des photons.

Pour cela, le silicium peut être recouvert d'une couche de matériau transparent et apte à absorber dans l'ultra-violet ou l'infrarouge pour réémettre dans le visible.

A cet égard, il a ainsi été mis en évidence que l'oxyde de zinc, ZnO, permet d'absorber des photons dans le domaine ultraviolet et réémet des photons dans le visible. Cependant, ces propriétés ne sont pas obtenues pour toute sorte de particules de ZnO, elles dépendent notamment de l'état de surface des particules, et des stabilisants/ligands organiques utilisés.

En outre, la mise en oeuvre de ce type de matériau nécessite de disposer d'un conditionnement stable dans le temps et dans les conditions d'utilisation. Ce matériau doit également être transparent, et facile à mettre en oeuvre.

Le document WO2010/068687 A1 décrit une composition comprenant un support aqueux ou non aqueux, et des particules de ZnO dispersées dans ledit support, les particules de ZnO n'ayant pas substantiellement de particules ayant une taille primaire de moins de 100 nm mesurée par microscopie électronique à transmission. Le document EP2497456 A1 décrit une composition cosmétique émulsifiée huile dans eau comprenant une poudre de ZnO (A) ayant un diamètre moyen de particules de 0,1 à 1 µm, une épaisseur moyenne de particules de 0,01 à 0,2 µm, et un facteur de forme moyen de 3 ou plus ; et un polymère (B) choisi parmi un polyacrylamide, un acide polyacrylique et un de leurs sels.

La présente invention concerne une composition stable de particules de ZnO suspendues en milieu aqueux qui permet de résoudre le problème technique concernant l'amélioration du rendement de cellules photovoltaïques à base de silicium, tout en restant stable dans le temps.

### EXPOSE DE L'INVENTION

La présente invention concerne une composition aqueuse de particules de ZnO suspendues présentant une stabilité accrue par rapport aux compositions de l'art antérieur, mais aussi un rendement de luminescence la rendant particulièrement adaptée pour une utilisation dans le domaine du photovoltaïque.

Le Demandeur a découvert que l'utilisation d'un stabilisant spécifique permettait de préparer une suspension aqueuse stable de particules de ZnO.

Plus précisément, la présente invention concerne une composition aqueuse comprenant une suspension de particules de ZnO et un stabilisant polymérique contenant des fonctions acide carboxylique et des fonctions sel d'acide carboxylique, ledit stabilisant polymérique étant à base des monomères suivants : acide acrylique et/ou acide méthacrylique ; sel d'acide acrylique et/ou sel d'acide méthacrylique.

Le stabilisant polymérique permet de maintenir les particules de ZnO en suspension et confère la stabilité nécessaire dans le temps. Ces propriétés résultent de la présence combinée des fonctions acide carboxylique et sel d'acide carboxylique.

Le stabilisant polymérique est avantageusement hydrosoluble. En d'autres termes, il est avantageusement soluble dans l'eau dans les conditions d'utilisation.

Contrairement aux compositions de l'art antérieur, cette suspension peut être déshydratée pour former une composition sous forme de poudre. La composition sous forme de poudre peut alors être redispersée dans l'eau et présenter également les propriétés initiales de stabilité.

Le stabilisant polymérique est à base des monomères suivants : acide acrylique et/ou acide méthacrylique ; sel d'acide acrylique et/ou sel d'acide méthacrylique. Il peut notamment s'agir de l'une des combinaisons suivantes :
- acide acrylique ; sel d'acide acrylique ;
- acide méthacrylique ; sel d'acide acrylique ;
- acide acrylique ; sel d'acide méthacrylique ;
- acide méthacrylique ; sel d'acide méthacrylique.

Il peut également s'agir d'un mélange d'acide acrylique et d'acide méthacrylique et leurs sels respectifs.

Selon un mode de réalisation particulier, le stabilisant polymérique peut notamment être un copolymère d'acide (méth)acrylique et de sel d'acide (méth)acrylique.

L'expression acide (méth)acrylique désigne l'acide acrylique ou l'acide méthacrylique ou le mélange acide acrylique + acide méthacrylique.

L'expression sel d'acide (méth)acrylique désigne le sel d'acide acrylique ou le sel d'acide méthacrylique ou le mélange sel d'acide acrylique + sel d'acide méthacrylique.

Dans ce cas, il peut s'agir d'un copolymère bloc obtenu par copolymérisation de monomères ayant une fonction acide carboxylique et de monomères ayant une fonction sel d'acide carboxylique. Il peut donc se présenter sous la forme d'un copolymère bloc comprenant au moins un bloc ayant des fonctions acide carboxylique et au moins un bloc ayant des fonctions sel d'acide carboxylique. Il peut également résulter de la neutralisation partielle des fonctions acides carboxylique d'un polymère tel que par exemple le poly(acide acrylique) ou le poly(acide méthacrylique).

Selon un autre mode de réalisation particulier, le stabilisant polymérique peut être un mélange d'un polymère d'acide (méth)acrylique et d'un polymère de sel d'acide (méth)acrylique.

Par sel d'acide carboxylique et sel d'acide acrylique, on entend respectivement la fonction carboxylate -C(=O)O⁻ A⁺ et la fonction acrylate CH₂=CH-C(=O)O⁻ A⁺, dans lesquelles le contre-ion A⁺ est avantageusement un cation d'un métal alcalin ou un ammonium (quaternaire, tertiaire, secondaire ou primaire). Le contre-ion est avantageusement choisi dans le groupe comprenant K⁺, Na⁺ ; Li⁺ ; et les ammoniums quaternaires tels que NR₄ avec R = alkyle contenant 1 à 18 atomes de carbone.

De manière avantageuse, le stabilisant est un mélange d'un homopolymère d'acide (méth)acrylique et d'un homopolymère d'un sel d'acide (méth)acrylique. Il peut notamment s'agir d'un mélange de poly(acide acrylique) et de poly(acrylate de sodium).

Le rapport molaire entre les fonctions acide carboxylique et les fonctions sel d'acide carboxylique est avantageusement compris entre 25/75 et 75/25, plus avantageusement entre 35/65 et 65/35, et encore plus avantageusement entre 45/55 et 55/45, avantageusement de l'ordre de 50/50. Cette plage de valeurs permet d'optimiser les propriétés de photoluminescente de la composition selon l'invention. Le rapport molaire entre les fonctions acide carboxylique et les fonctions sel d'acide carboxylique correspond au rapport entre le nombre de groupements COOH et COO⁻.

Selon un autre mode de réalisation, le rapport massique entre les fonctions acide carboxylique et les fonctions sel d'acide carboxylique est avantageusement compris entre 25/75 et 75/25, plus avantageusement entre 35/65 et 65/35, et encore plus avantageusement entre 45/55 et 55/45, avantageusement de l'ordre de 50/50. Ce mode de réalisation est particulièrement adapté aux mélanges de polymères, par exemple au mélange d'un polymère d'acide (méth)acrylique et d'un polymère de sel d'acide (méth)acrylique.

De manière avantageuse, le ou les polymères constituant le stabilisant polymérique présente, le cas échéant indépendamment l'un de l'autre, un poids moléculaire compris entre 500 et 240000 g/mol, plus avantageusement entre 1000 et 100000g/mol, et encore plus avantageusement entre 1500 et 5000g/mol.

L'utilisation de polymère(s) ayant un poids moléculaire inférieur ou égal à 240000 g/mol permet d'optimiser le rendement quantique de la composition selon l'invention.

Par « poids moléculaire », on entend le poids moléculaire moyen du polymère. Les connaissances générales de l'homme du métier lui permettront de le mesurer selon les techniques conventionnelles.

Le ou les polymères constituant le stabilisant polymérique peut également comprendre au moins un co-monomère additionnel ne comprenant pas de fonctions acide carboxylique ou carboxylate. Il peut notamment s'agir de monomères non-ioniques, cationiques et/ou anioniques. A titre d'exemple, ce type de co-monomère peut notamment être le (méth)acrylamide ou un dérivé de (méth)acrylamide.

Typiquement, le stabilisant peut représenter 0,01 à 10 % en poids par rapport au poids de la composition aqueuse de particules de ZnO, plus avantageusement entre 0,1 et 3 %, plus avantageusement entre 0,5 et 1 %, et encore plus avantageusement entre 0,5 et 0,7 %. Ce pourcentage représente le pourcentage (concentration) massique total de stabilisant, notamment lorsqu'il est constitué d'un mélange de polymères.

Selon un mode de réalisation avantageux, la composition aqueuse de particules de ZnO comprend entre 0,5 et 1 % en poids, avantageusement entre 0,5 et 0,7 %, de stabilisant qui est constitué d'un mélange de :
- poly(acide (méth)acrylique) ayant un poids moléculaire inférieur ou égal à 240000 g/mol, avantageusement compris entre 2000 et 100 000 g/mol, plus avantageusement le poly(acide acrylique) ; et de
- poly((méth)acrylate de sodium) ayant un poids moléculaire inférieur ou égal à 240000 g/mol, avantageusement compris entre 4000 et 100 000 g/mol, plus avantageusement le poly(acrylate de sodium).

En outre, les particules de ZnO représentent avantageusement 0,01 à 20 % en poids du poids de la composition aqueuse, plus avantageusement entre 0,05 et 10 %, et encore plus avantageusement entre 0,1 et 2 %.

De manière générale, les particules de ZnO présentent un diamètre moyen pouvant être inférieur à 100 nanomètres, plus avantageusement inférieur à 20 nanomètres, encore plus avantageusement compris entre 2 et 15 nanomètres. Ainsi, sont évités les problèmes de faible transparence rencontrés avec les particules de taille supérieure.

Elles se présentent avantageusement sous la forme coeur/coquille, le coeur étant en ZnO et la coquille en stabilisant polymérique.

D'autre part, les particules de ZnO sont avantageusement cristallines.

Le rapport massique particules de ZnO/stabilisant polymérique est avantageusement compris entre 40 et 80 %, plus avantageusement entre 50 et 60%.

La présente invention concerne également la composition déshydratée obtenue par élimination de l'eau de la composition aqueuse décrite ci-dessus.

L'élimination de l'eau peut notamment être réalisée par lyophilisation ou par évaporation. A titre d'exemple, elle peut être réalisée au moyen d'un évaporateur rotatif, à une température de 60 °C et une pression de 70 bar.

L'élimination d'eau peut être totale ou partielle. Elle peut avoir pour but de concentrer la composition en particules de ZnO. A cet égard, nous soulignons que les gammes de concentration mentionnées ci-dessus concernent la composition à l'issue de sa préparation, et avant toute éventuelle élimination d'eau.

En effet, le Demandeur a remarqué que de manière tout à fait inattendue, la composition aqueuse peut être séchée par toute technique faisant partie des connaissances générales de l'homme du métier, puis reformée par addition d'eau. Les particules de ZnO sont alors à nouveau suspendues de manière stable. Au contraire, l'addition du stabilisant ayant des fonctions acide carboxylique et sel d'acide carboxylique à une composition solide ou aqueuse de particules de ZnO de l'art antérieur ne permet pas d'obtenir cet effet. La suspension résultante est alors instable.

Ainsi, la composition selon l'invention peut être concentrée. La concentration en particules de ZnO et la viscosité de la composition peuvent donc être ajustées afin d'améliorer la mise en oeuvre en fonction des éventuelles applications. Une composition visqueuse peut permettre un dépôt plus épais qu'une composition diluée. Ceci est particulièrement important pour le domaine d'application du photovoltaïque qui peut impliquer le dépôt de la composition sur un substrat en verre par exemple.

La présente invention concerne en outre le procédé de préparation de la composition aqueuse comprenant une suspension de particules de ZnO. Ce procédé comprend les étapes suivantes :
- préparation d'une solution aqueuse comprenant un stabilisant contenant des fonctions acide carboxylique et des fonctions sel d'acide carboxylique ;
- addition d'un précurseur de zinc ;
- formation de particules de ZnO par hydrolyse du précurseur de zinc ;
- obtention d'une composition aqueuse comprenant une suspension de particules de ZnO et un stabilisant polymérique.

Dans ce procédé, l'addition du précurseur de zinc est réalisée après celle du stabilisant.

En outre, ce procédé est avantageusement mis en oeuvre à pression et température ambiantes.

Le précurseur de zinc mis en oeuvre est hydrolysable. Il peut notamment être choisi dans le groupe comprenant ZnR₂ ; Zn(OR)₂ ; Zn(NR₂)₂ ; Zn(O-C(=O)R)₂ ; R étant un groupement hydrocarboné comprenant 1 à 18 atomes de carbone, avantageusement un groupement alkyle comprenant 1 à 4 atomes de carbone.

Selon un mode de réalisation préféré, le précurseur de zinc est le Zn(Et)₂.

Quand bien même la présente invention concerne une composition aqueuse, il n'est pas exclu qu'elle comprenne également des traces de solvant organique. C'est notamment le cas lorsque le précurseur de zinc est commercialisé dans un solvant organique, du toluène par exemple.

Dans ce cas, il est possible d'éliminer toute trace de solvant (et éventuellement d'eau), de manière à obtenir une poudre de particules de ZnO et de stabilisant. Comme déjà indiqué, ces particules de ZnO peuvent alors être re-dispersées dans l'eau pour obtenir à nouveau une suspension de particules. La composition résultante est alors dépourvue de toute trace de solvant organique.

La présente invention concerne également l'utilisation de la composition aqueuse de particules de ZnO suspendues, dans le domaine des cellules photovoltaïques ; la peinture ; la cosmétique ; des textiles ; de l'électronique (diodes, transducteurs, lasers) ; des bio-capteurs ; des revêtements anti-microbiens et anti-fouling.

La présence du stabilisant permet l'obtention d'une suspension homogène et de déposer de manière homogène les particules de ZnO sur un substrat, améliorant ainsi les propriétés du substrat (fongicide, bactéricide, conversion UV-visible).

La composition aqueuse selon l'invention présente de nombreux avantages la rendant particulièrement adaptée pour une utilisation dans le domaine photovoltaïque :
- possibilité de concentrer la composition notamment pour ajuster sa viscosité et ainsi faciliter sa mise en oeuvre mais également son transport ;
- transparence dans le domaine d'absorption du silicium cristallin (300 et 1100 nm) ;
- aptitude à absorber des photons dans le domaine ultraviolet et à réémettre des photons dans le visible et du proche infrarouge (généralement entre 300 et 1100 nm), ce qui améliore le rendement énergétique d'une cellule photovoltaïque à base de silicium.

L'invention et les avantages qui en découlent ressortiront mieux des figures et exemples suivants donnés afin d'illustrer l'invention et non de manière limitative.

### DESCRIPTION DES FIGURES

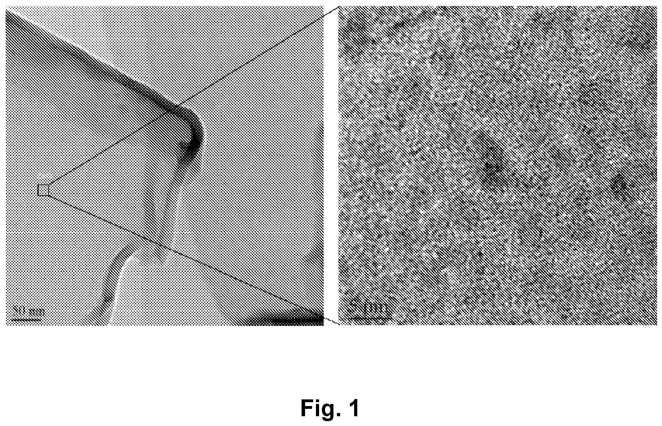

La figure 1 représente une image obtenue par microscopie électronique en transmission d'une suspension aqueuse de ZnO selon l'invention dont le stabilisant polymérique présente un rapport molaire de fonctions acide carboxylique / fonctions sel d'acide carboxylique égal à 50/50.

### EXEMPLES DE REALISATION DE L'INVENTION

### 1/ Influence du rapport ou massique acide carboxylique/carboxylate (COOH / COO-) sur la formation d'une suspension stable.

Huit compositions comprenant des particules de ZnO ont été préparées. Ces compositions comprennent toutes 0,63% en poids de stabilisant et 0,65 % en poids de particules de ZnO.

La nature du stabilisant mis en oeuvre est précisée dans le tableau 1, que ce soit pour les compositions selon l'invention (INV-1 à INV-6) ou pour les contre-exemples (CE-1 et CE-2).

**Tableau 1 : Nature du stabilisant selon les compositions préparées (pourcentages massiques).**

| Exemples | CE-1 | INV-1 | INV-2 | INV-3 | INV-4 | INV-5 | INV-6 | CE-2 |
|---|---|---|---|---|---|---|---|---|
| PAAH | 0% | 25% | 35% | 50% | 65% | 70% | 75% | 100% |
| PAA-Na | 100% | 75% | 65% | 50% | 35% | 30% | 25% | 0% |

| | | | | | | | | |
|---|---|---|---|---|---|---|---|---|
| PAAH : poly(acide acrylique) (2000 g/mol) PAA-Na : poly(acrylate de sodium) (4000 g/mol) | | | | | | | | |

Les compositions ont été préparées selon le mode opératoire suivant :
- introduction du stabilisant dans 25mL d'eau ;
- introduction goutte à goutte et sous agitation de 2,0 mmol de diéthyl zinc (1,8 ml de solution commerciale à 15% massique dans le toluène) ;
- hydrolyse de ZnEt₂ et formation d'éthane selon la réaction suivante :

   ZnEt₂ + H₂O → ZnO + 2 EtH

L'agitation est maintenue pendant 1 ou 24 heures à température ambiante, de préférence 1 heure.

La composition ainsi obtenue se présente sous la forme :
- d'une suspension limpide (INV-2 à INV-5)
- d'une suspension turbide (INV-1 et INV-6) ;
- d'une poudre non dispersable dans l'eau mais dispersable dans un mélange eau+PAAH (CE-1 et CE-2). Dans ce cas, les poudres redispersées dans eau + PAAH réémettent dans l'UV, ce qui n'est pas compatible avec une utilisation dans le domaine photovoltaïque.

Afin de caractériser ces compositions, elles ont été lyophilisées.

**Tableau 2 : Caractérisation des compositions lyophilisées de particules de ZnO.**

| Exemples | CE-1 | INV-1 | INV-2 | INV-3 (figure 1) | INV-4 | INV-5 | INV-6 | CE-2 |
|---|---|---|---|---|---|---|---|---|
| Aspect | - | + | ++ | ++ | ++ | ++ | + | - |
| QY | 4% | 2% | 8% | 20-25% | 5% | 11% | 7% | 20-36% |
| λ (nm) | 620 | 540 | 540 | 530 | 420 | 380 | 400 | 550 |
| pH | 8,9 | 10,8 | 10,7 | 10,0 | 8,9 | 8,8 | 8,6 | 3,4 |

| | | | | | | | | |
|---|---|---|---|---|---|---|---|---|
| λ correspond à la longueur d'onde d'émission maximale. Aspect de la composition : - : poudre et solution surnageante, et poudre non redispersable dans l'eau + : suspension trouble, et poudre lyophilisée redispersable dans l'eau ++ : suspension claire, stable pendant plusieurs mois, et poudre lyophilisée redispersable dans l'eau | | | | | | | | |

Les résultats présentés dans le tableau 2 montrent que les meilleurs résultats en termes de photoluminescence et de QY sont obtenus lorsque le stabilisant est du PAAH à 100% (CE-2). Cependant, la composition aqueuse CE-2 ne comprend pas de suspension de particules de ZnO.

En ce qui concerne, les compositions selon l'invention, la composition INV-3 (50% PAAH et 50% PAA-Na) émet à 530 nm et présente un rendement de luminescence entre 20 et 25%, ce qui lui confère des propriétés très intéressantes pour une utilisation dans le domaine du photovoltaïque.

Sans vouloir émettre une quelconque hypothèse, le Demandeur considère que les fonctions acide carboxylique permettent de greffer les particules de ZnO alors que les fonctions sel d'acide carboxylique permettent de disperser les particules de ZnO sans se greffer sur celles-ci.

Le rendement quantique QY (de l'acronyme anglais *« Quantum Yield* ») correspond au nombre de photons émis par rapport au nombre de photons absorbés. Il est exprimé en pourcentage.

### 2/ Influence de la quantité de stabilisant polymérique sur la formation d'une suspension stable.

Les exemples suivants concernent des compositions obtenues par hydrolyse de ZnEt₂ en présence de 3,15 % à 0,126% en poids de stabilisant polymérique constitué de 50% en poids de PAAH (2000g/mol) et de 50% en poids de PAA-Na (4000g/mol). Dans ces exemples, le rapport massique en fonctions COOH et COO- reste stable, seule la concentration massique du stabilisant PAAH + PAA-Na change.

**Tableau 3 : QY en fonction de la quantité de stabilisant.**

| | INV-7 | INV-8 | INV-9 | INV-10 | INV-11 |
|---|---|---|---|---|---|
| Quantité de stabilisant PAAH + PAA-Na | 0,126 | 0,315 | 0,63 | 1,26 | 3,15 |
| QY | 2 | 14 | 25 | 6 | 6 |
| Aspect | ++ | ++ | ++ | ++ | ++ |

| | | | | | |
|---|---|---|---|---|---|
| Aspect de la composition : ++ : suspension claire, stable pendant plusieurs mois, et poudre lyophilisée redispersable dans l'eau | | | | | |

Les exemples INV-7 à INV-9 permettent d'obtenir des suspensions stables et claires avec une émission maximum se situant entre 500 et 600 nm. Pour les exemples INV-10 et INV-11, l'émission est décalée entre 350 et 450nm.

En outre, plus la quantité de stabilisant est importante, plus le composé est amorphe et plus la perte en masse observée en ATG (analyse thermogravimétrique) est importante. Pour ces composés les moins cristallins, la bande de luminescence est déplacée vers les hautes-énergies (blue-shift) entre 350 et 450nm.

### 3/ Influence du poids moléculaire du stabilisant polymérique sur la formation d'une suspension stable.

Les exemples suivants concernent des compositions obtenues par hydrolyse de ZnEt₂ en présence d'un stabilisant polymérique présentant un poids moléculaire compris entre 2 000 et 240 000 g/mol (tableau 4).

Ces exemples concernent une suspension de ZnO contenant 0,63% massique de stabilisant polymérique PAAH/PAA-Na (mélange 50:50 en poids), le poids moléculaire du PAAH variant de 2 000 à 240 000 g/mol, et le poids moléculaire du PAA-Na variant de 2 000 à 240 000 g/mol. Dans toutes ces compositions, le rapport massique COOH / COO- reste égal à 50/50.

Le PAA-Na mis en oeuvre est préalablement obtenu par polymérisation d'acrylate de sodium ou par neutralisation du poly(acide acrylique) par addition de soude.

Tous ces exemples ont conduit à l'obtention d'une suspension claire et stable pendant plusieurs mois, dont la poudre lyophilisée est redispersable dans l'eau.

De manière générale, plus la chaîne de PAA-Na est longue (poids moléculaire élevé), par rapport à celle du PAAH, plus la suspension est obtenue rapidement.

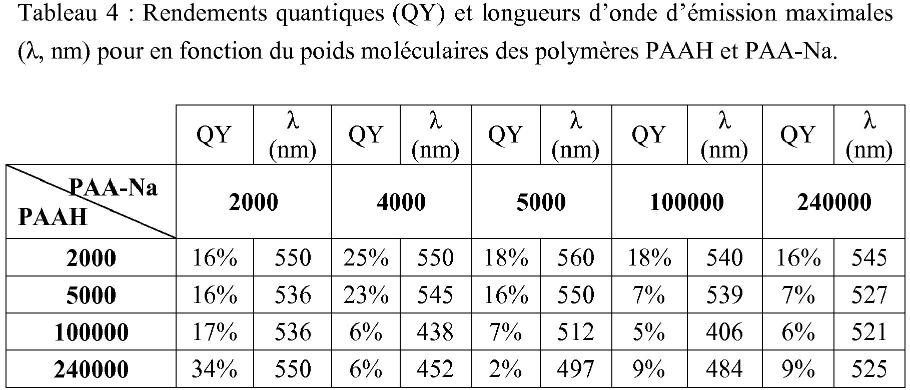

Le tableau 4 donne les rendements quantiques (QY) pour différents mélange de PAAH/PAA-Na (rapport en poids 50/50) en fonction de leur poids moléculaire.

Ces compositions émettent dans les longueurs d'onde correspondant aux couleurs vertorange, ce qui plus avantageux pour des applications dans les cellules photovoltaïques qu'une émission dans le bleu.

### 4/ Rendement quantique en fonction du mélange PAAH/PAA-Na.

Les exemples suivants concernent des compositions obtenues par hydrolyse de ZnEt₂ en présence de 0,4 à 1% en poids de stabilisant polymérique (PAAH + PAA-Na) constitué de 50% en poids de PAAH (2000g/mol) et de 50 % en poids de PAA-Na (4000g/mol). Dans cette composition, le rapport molaire COOH / COO- varie en fonction des pourcentages (concentrations) massiques initiaux des solutions de PAAH et de PAANa.

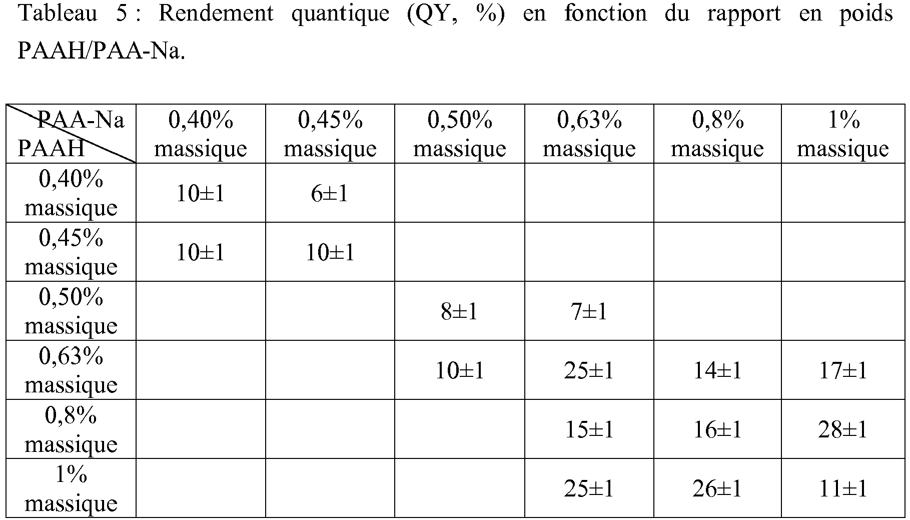

Selon le tableau 5, les meilleurs résultats de rendement quantique (QY) sont obtenus lorsque la composition comprend 0,63 à 1% en poids de PAAH et 0,63 à 1% en poids de PAA-Na.

Dans ces exemples, une composition contenant 1% massique de stabilisant (PAAH + PAA-Na) est obtenue à partir d'un mélange de 50% massique d'une première solution de PAAH à 1%massique et de 50% massique d'une deuxième solution de PAA-Na à 1% massique.

## Revendications

1. Composition aqueuse comprenant une suspension de particules de ZnO et un stabilisant polymérique contenant des fonctions acide carboxylique et des fonctions sel d'acide carboxylique, ledit stabilisant polymérique étant à base des monomères suivants : acide acrylique et/ou acide méthacrylique ; sel d'acide acrylique et/ou sel d'acide méthacrylique.

2. Composition selon la revendication 1, **caractérisée en ce que** le stabilisant polymérique est un copolymère d'acide (méth) acrylique et de sel d'acide (méth)acrylique.

3. Composition selon la revendication 1, **caractérisée en ce que** le stabilisant polymérique est un mélange d'un polymère d'acide (méth)acrylique et d'un polymère de sel d'acide (méth)acrylique.

4. Composition selon l'une des revendications 1 à 3, **caractérisée en ce que** le rapport molaire entre les fonctions acide carboxylique et les fonctions sel d'acide carboxylique est compris entre 25/75 et 75/25.

5. Composition selon la revendication 3, **caractérisée en ce que** le stabilisant polymérique est un mélange d'un polymère d'acide (méth)acrylique et d'un polymère de sel d'acide (méth)acrylique, ce mélange présentant un rapport massique compris entre 25/75 et 75/25.

6. Composition selon l'une des revendications 1 à 5, **caractérisée en ce que** le stabilisant représente 0,01 à 10 % en poids par rapport au poids de la composition aqueuse.

7. Composition selon l'une des revendications 1 à 6, **caractérisée en ce que** les particules de ZnO représentent 0,1 à 20 % en poids par rapport au poids de la composition aqueuse.

8. Composition selon l'une des revendications 1 à 7, **caractérisée en ce qu'**elle comprend entre 0,5 et 0,7 % en poids de stabilisant polymérique ;
le stabilisant polymérique étant constitué d'un mélange de :
- poly(acide (méth)acrylique) ayant un poids moléculaire inférieur ou égal à 240000 g/mol ; et de
- poly((méth)acrylate de sodium) ayant un poids moléculaire inférieur ou égal à 240000 g/mol.

9. Composition selon l'une des revendications 1 à 8, **caractérisée en ce qu'**elle est déshydratée.

10. Procédé de préparation de la composition objet de l'une des revendications 1 à 9, comprenant les étapes suivantes :
- préparation d'une solution aqueuse comprenant un stabilisant polymérique contenant des fonctions acide carboxylique et des fonctions sel d'acide carboxylique ;
- addition d'un précurseur de zinc ;
- formation de particules de ZnO par hydrolyse du précurseur de zinc ;
- obtention d'une composition aqueuse comprenant une suspension de particules de ZnO et un stabilisant polymérique.

11. Procédé selon la revendication 10, **caractérisé en ce que** le précurseur de zinc est choisi dans le groupe comprenant ZnR₂ ; Zn(OR)₂ ; Zn(NR₂)₂ ; Zn(O-C(=O)R)₂ ; R étant un groupement hydrocarboné comprenant 1 à 18 atomes de carbone.

12. Utilisation de la composition objet de l'une des revendications 1 à 9, dans le domaine des cellules photovoltaïques ; la peinture ; la cosmétique ; des textiles ; de l'électronique (diodes, transducteurs, lasers) ; des bio-capteurs ; des revêtements anti-microbiens et anti-fouling.

## Patentansprüche

1. Wässrige Zusammensetzung, die eine Suspension von ZnO-Partikel und einen polymeren Stabilisator umfasst, der Carbonsäurefunktionen und Carbonsäuresalzfunktionen enthält, wobei der polymere Stabilisator auf den folgenden Monomeren basiert: Acrylsäure und/oder Methacrylsäure; Acrylsäuresalz und/oder Methacrylsäuresalz.

2. Zusammensetzung nach Anspruch 1, **dadurch gekennzeichnet, dass** der polymere Stabilisator ein Copolymer aus (Meth)acrylsäure und (Meth)acrylsäuresalz ist.

3. Zusammensetzung nach Anspruch 1, **dadurch gekennzeichnet, dass** der polymere Stabilisator eine Mischung aus einem (Meth)acrylsäure-Polymer und einem (Meth)acrylsäuresalz-Polymer ist.

4. Zusammensetzung nach einem der Ansprüche 1 bis 3, **dadurch gekennzeichnet, dass** das Molverhältnis zwischen den Carbonsäurefunktionen und den Carbonsäuresalzfunktionen im Bereich zwischen 25/75 und 75/25 liegt.

5. Zusammensetzung nach Anspruch 3, **dadurch gekennzeichnet, dass** der polymere Stabilisator eine Mischung aus einem (Meth)acrylsäure-Polymer und einem (Meth)acrylsäuresalz-Polymer ist, wobei diese Mischung ein Massenverhältnis im Bereich zwischen 25/75 und 75/25 aufweist.

6. Zusammensetzung nach einem der Ansprüche 1 bis 5, **dadurch gekennzeichnet, dass** der Stabilisator 0,01 bis 10 Gew.-%, bezogen auf das Gewicht der wässrigen Zusammensetzung, ausmacht.

7. Zusammensetzung nach einem der Ansprüche 1 bis 6, **dadurch gekennzeichnet, dass** die ZnO-Partikel 0,1 bis 20 Gew.-%, bezogen auf das Gewicht der wässrigen Zusammensetzung, ausmachen.

8. Zusammensetzung nach einem der Ansprüche 1 bis 7, **dadurch gekennzeichnet, dass** sie zwischen 0,5 und 0,7 Gew.-% polymeren Stabilisator umfasst;
wobei der polymere Stabilisator aus einer Mischung besteht aus:
- Poly((meth)acrylsäure) mit einem Molekulargewicht von kleiner oder gleich 240 000 g/mol; und aus
- Poly((meth)natriumacrylat) mit einem Molekulargewicht von kleiner oder gleich 240 000 g/mol.

9. Zusammensetzung nach einem der Ansprüche 1 bis 8, **dadurch gekennzeichnet, dass** sie dehydriert ist.

10. Verfahren zur Herstellung der Zusammensetzung nach einem der Ansprüche 1 bis 9, das die folgenden Schritte umfasst:
- Herstellen einer wässrigen Lösung, die einen polymeren Stabilisator umfasst, der Carbonsäurefunktionen und Carbonsäuresalzfunktionen enthält;
- Zugeben eines Zinkvorläufers;
- Bilden von ZnO-Partikeln durch Hydrolyse des Zinkvorläufers;
- Erhalten einer wässrigen Zusammensetzung, die eine Suspension von ZnO-Partikeln und einen polymeren Stabilisator umfasst.

11. Verfahren nach Anspruch 10, **dadurch gekennzeichnet, dass** der Zinkvorläufer ausgewählt ist aus der Gruppe die ZnR₂; Zn(OR)₂; Zn(NR₂)₂; Zn(O-C(=O)R)₂ umfasst; wobei R eine Kohlenwasserstoffgruppe ist, die 1 bis 18 Kohlenstoffatome umfasst.

12. Verwendung der Zusammensetzung nach einem der Ansprüche 1 bis 9, im Bereich der Photovoltaikzellen; Farbe; Kosmetik; Textilien; Elektronik (Dioden, Wandler, Laser); Biosensoren; antimikrobiellen und Antifouling-Beschichtungen.

## Claims

1. An aqueous composition comprising a suspension of ZnO particles and a polymeric stabiliser containing carboxylic acid functions and carboxylic acid salt functions, said polymeric stabiliser being based on the following monomers: acrylic acid and/or methacrylic acid; acrylic acid salt and/or methacrylic acid salt.

2. The composition according to claim 1, **characterised in that** the polymeric stabiliser is a copolymer of (meth)acrylic acid and (meth)acrylic acid salt.

3. The composition according to claim 1, **characterised in that** the polymeric stabiliser is a mixture of a (meth)acrylic acid polymer and a (meth)acrylic acid salt polymer.

4. The composition according to one of claims 1 to 3, **characterised in that** the molar ratio of the carboxylic acid functions to the carboxylic acid salt functions is between 25/75 and 75/25.

5. The composition according to claim 3, **characterised in that** the polymeric stabiliser is a mixture of a (meth)acrylic acid polymer and a (meth)acrylic acid salt polymer, this mixture having a mass ratio of between 25/75 and 75/25.

6. The composition according to one of claims 1 to 5, **characterised in that** the stabiliser represents 0.01 to 10% by weight relative to the weight of the aqueous composition.

7. The composition according to one of claims 1 to 6, **characterised in that** the ZnO particles represent 0.1 to 20% by weight relative to the weight of the aqueous composition.

8. The composition according to one of claims 1 to 7, **characterised in that** it comprises between 0.5 and 0.7% by weight of polymeric stabiliser;
the polymeric stabiliser consisting of a mixture of:
- poly((meth)acrylic acid) having a molecular weight less than or equal to 240,000 g/mol; and of
- poly(sodium (meth)acrylate) having a molecular weight less than or equal to 240,000 g/mol.

9. The composition according to one of claims 1 to 8, **characterised in that** it is dehydrated.

10. A method for preparing the composition as claimed in one of claims 1 to 9, comprising the following steps:
- preparing an aqueous solution comprising a polymeric stabiliser containing carboxylic acid functions and carboxylic acid salt functions;
- adding a zinc precursor;
- forming ZnO particles by hydrolysis of the zinc precursor;
- obtaining an aqueous composition comprising a suspension of ZnO particles and a polymeric stabiliser.

11. The method according to claim 10, **characterised in that** the zinc precursor is selected from the group comprising ZnR₂; Zn(OR)₂; Zn(NR₂)₂; Zn(O-C(=O)R)₂; R being a hydrocarbon group comprising 1 to 18 carbon atoms.

12. Use of the composition as claimed in one of claims 1 to 9, in the field of photovoltaic cells; painting; cosmetics; textiles; electronics (diodes, transducers, lasers); bio-sensors; anti-microbial and anti-fouling coatings.
